# EUROPEAN PATENT SPECIFICATION

(11) **EP 1 684 561 B1**
(45) Date of publication and mention of the grant of the patent: **22.08.2007**
(21) Application number: 05352002.9
(22) Date of filing: 21.01.2005
(51) Int. Cl.: H05K 7/20, H01L 23/36

(54) **Device permitting heat transfer, especially from a component or electronic card to a framework or to a heat dissipator linked to said framework**
Vorrichtung, die die Wärmeübertragung, insbesondere aus einem Bauelement oder einer elektronischen Karte zu einem Rahmen oder zu einem mit dem Rahmen verbundenen Kühler, erlaubt
Dispositif permettant le transfer de chaleur, en particulier à partir d'un composant ou d'une carte électronique vers un châssis ou vers un dissipateur de chaleur rélié au châssis

(43) Date of publication of application: 26.07.2006
(73) Proprietor: Barcoview Texen, 31100 Toulouse (FR)
(72) Inventor: Blandin, Laurent, 31037 Toulouse Cedex 01 (FR)
(74) Representative: Morelle, Guy Georges Alain

(56) References cited:
- US-A- 4 689 720
- US-A- 5 812 374
- US-A- 5 896 269
- US-A1- 2002 182 900

## Description

The present invention relates to devices which permit heat transfer, especially from a component or an electronic card to a framework in which it is intended to be mounted, or to a heat dissipator linked to said framework, this essentially with a view to cooling down the component or the electronic card and to controlling especially its operating temperature, see for example US-A-5812374.

When a component or an electronic card which needs to be cooled down is arranged in an enclosure distant from the heat-conducting framework or from a heat dissipator linked to this framework, or when the mechanical construction tolerances of the framework are wide and consequently cause the distance between the component or the electronic card and the framework to vary from one framework to another, it is necessary to mount a unit of heat-conducting material, generally as one piece and solid, therefore heavy, connecting the component or the electronic card to the framework or to the heat dissipator to permit the transfer of heat by conduction from the component or the card to be cooled to the framework which itself is heat-conducting, then to the exterior of the enclosure and thus ensure the cooling.

The document US 6,205,023 is known, for example, which proposes a device for cooling a heat source placed in an electronic unit, the heat source needing to be maintained at an operating temperature which is lower than an authorised temperature, said device comprising a mobile heat dissipator capable of coming into contact with the heat source and an external heat dissipator of the framework of the electronic unit. The mobile heat dissipator is guided in its displacement in slides realised in the framework, in order to permit a passage to be freed for mounting the heat source in the enclosure, for example an electronic card, and then to be able to come into contact simultaneously with the heat source and with the framework or with the external dissipator. In order to ensure heat-conducting contact between a plurality of electronic components situated on an electronic card and the mobile dissipator, a thermal mat, composed of heat-conducting silicon rubber, is interposed between the latter and the heat source.

These solutions have the disadvantage of proposing, for transferring the heat from the source to the framework, a unit or mobile dissipator which is thick and solid, therefore heavy, and which moreover only permits a transfer of heat by conduction. Furthermore in the case of the mobile dissipator, its positioning and manipulation for assembly lead to increased manufacturing time, and even malfunctioning due to the guiding system.

The present invention makes it possible to overcome these disadvantages and provide other advantages. More precisely it consists in a device permitting heat transfer, especially from a component or an electronic card to a framework in which it is intended to be mounted or to a heat dissipator linked to said framework, characterised in that the device comprises:
- a heat-conducting support intended to be connected to the framework or heat dissipator by a first heat-conducting link,
- a heat-conducting collector, intended to be connected to the component or electronic card by a second heat-conducting link,
- resilient heat-conducting means connecting the heat-conducting support and collector by a resilient heat-conducting link, comprising a plurality of flexible strips.

The device according to the invention makes it possible, thanks to its arrangement in the form of two heat-conducting elements connected by resilient heat-conducting means, to propose mainly an autonomous heat dissipator, which can be realised advantageously in the factory, and which is able to be adapted rapidly with a minimum mounting time due to the absence of a multi-position guiding system, making it possible to connect a source of heat to a heat-conducting framework or a dissipator linked to the framework by one and the other of the heat-conducting elements of the device respectively, the resilient heat-conducting means between these two heat-conducting elements permitting a resilient heat-conducting link allowing wide manufacturing tolerances compensated by a variable distance between the collector and the heat-conducting support, said distance being induced by the resilient link between these two elements, and allowing a displacement of the collector in relation to the support so as to permit easy assembly or disassembly of the component or of the card to be cooled down, the resilient heat-conducting link coming then automatically to ensure, especially at the end of assembly, an optimised contact between the collector and the component or the card to be cooled down, as a result of the pressure exerted by the resilient means. Thus the time for mounting said component or card is notably reduced whilst the efficiency of the heat transfer is increased.

According to an advantageous feature, one of said first or second heat-conducting links is a rigid link, the other being a link by contact, the support or collector which ensures said link by contact being rigid.

The pressure induced by the resilient heat-conducting means makes it possible to envisage only one rigid heat-conducting link from the device to its surroundings, for example to the framework or heat dissipator or in an alternative manner to the component or the electronic card according to the most appropriate case depending on the envisaged applications. Furthermore thanks to the resilient heat-conducting link, by simple contact, the device according to the invention makes it possible to reduce the mechanical fixing stresses caused on the component or the electronic card to be cooled down, stresses which are very disadvantageous on electronic components welded to an electronic card.

According to an advantageous feature, the first heat-conducting link is a rigid link, the second heat-conducting link being a link by contact.

The link by simple contact under the effect of the pressure exerted by the resilient means can be optimised by a heat-conducting product with a semi-fluid consistency, for example a heat-conducting contact lubricant or similar, improving the contact surface between the support or the collector, and the framework or heat dissipator on the one hand, or the component or the electronic card on the other hand respectively, depending on the quality of the surface, in terms of roughness, of the elements in contact.

According to an advantageous feature, the resilient heat-conducting means connect the support and the collector in such a way that the latter may adopt at least two positions, a first position, termed rest position, in which the resilient heat-conducting means are relaxed and a second position, termed operating position, in which the resilient heat-conducting means are compressed.

Such a feature permits the insertion of an electronic card or of a component to be cooled down, the rest position being adopted by the device according to the invention when the component or the card is not in place in the framework, for example the framework of the enclosure in which the component or the card is intended to be mounted, and the operating position being adopted when the component or the card is in place in the framework.

According to an advantageous feature, the resilient heat-conducting means are arranged in such a way as to permit a resilient displacement in translation of the collector in relation to the support.

This feature makes it possible to guarantee, during the resilient displacement of the collector, a predetermined position of the heat-conducting collector in relation to the heat-conducting support, which the displacement in translation does not modify, and thus to guarantee a predetermined position of the collector in relation to the framework, and thus in relation to the component or the electronic card which has to come into contact with the collector. Thus the predetermined thermal contact between the collector and the component or the card is maintained during the displacement of the collector.

According to an advantageous feature, the support and the collector are parallel or substantially parallel in the operating position.

In the case of an electronic card to be cooled down which is placed parallel to the portion of the framework to which is linked the heat-conducting support of the device according to the invention, the parallel alignment of the support and of the collector corresponds to the parallel alignment of the card to be cooled down and of the portion of the framework to which the device transfers the heat.

According to an advantageous feature, the heat-conducting support and collector respectively take the form of a first and a second rigid heat-conducting plate, and according to another feature the resilient heat-conducting means are arranged in such a way that a thrust force parallel to the second plate and on same brings about a displacement of the second plate towards the first plate, compressing the resilient heat-conducting means.

The arrangement of the collector in the form of a plate makes it possible to offer a light and resistant rigid element in the case of a thrust along the thickness of the plate whilst permitting a wide thermal contact surface for the transfer of a heat flow which is the most appropriate possible, for example the largest possible, from the surface of the plate. The plate should assume the compression of the resilient linking means with minimal deformation making it possible to guarantee thermal contact between the collector and the component or the card to be cooled down, both during the displacement of the collector and at the end of displacement, i.e. when the card is in place in the framework and the thermal link between the latter and the card is established.

According to an advantageous feature, the second plate includes an engagement bevel intended to facilitate the sliding of the component or the electronic card on the second plate.

The height of the bevel will preferably be equal to the displacement of the collector towards the support.

According to an advantageous feature, the flexible strips are rigidly fixed to the heat-conducting support and to the heat-conducting collector, respectively.

This feature makes it possible to ensure a transfer of the heat flow via the strips of the collector to the support, offering a light heat-transfer device, the weight of which is notably reduced in relation to a solid conducting unit. In addition, the strips permit an element to assume the double function of heat transmission and resilient return motion. Moreover the strips make it possible to facilitate the transfer of heat from the component or the card to be cooled down towards the ambient surroundings by convection, thanks to a possible circulation of air between the strips, providing the device according to the invention with an evacuation of the heat from the component or the plate to be cooled down by conduction towards the framework and by convection towards the ambient air of the enclosure in which the component or the card is installed, which is very useful when the enclosure is moreover cooled down by means of at least one ventilator ensuring the circulation of air in said enclosure.

According to an advantageous feature, the flexible strips of the plurality of strips each assume substantially an S- or Z-shape such that it enables the collector to be given a displacement in a direction perpendicular to the support and towards the latter, and in a combined manner, a displacement in a direction parallel to the support, a first branch of the S or of the Z being fixed to the heat-conducting support, the second branch of the S or of the Z being fixed to the heat-conducting collector.

This feature makes it possible to use best the resilient strips by giving them a supplementary function of guiding the movement of the collector in its displacement, depending on the way the component or the card to be cooled down is mounted in the framework, so that these flexible strips serve as guidance for the collector and allow a specific displacement of the latter in relation to the support.

This feature permits a displacement of the collector towards the support combining the sliding of the collector relative to the support in a plane parallel to the latter, and a displacement of the collector towards the support, such a movement being useful for facilitating the insertion of an electronic card in the framework by sliding in its housing whilst the collector is pushed back slightly towards the support under the thrust of the card, the collector also moving slightly in the sliding direction of the card to reduce its resistance to the displacement of the latter.

According to an advantageous feature, the resilient strips of the plurality of strips each assume a symmetrical shape in relation to a plane parallel to the first and second rigid plates.

This feature makes it possible to give the collector, via the flexible strips, a displacement essentially in a direction perpendicular to the support and towards same, the elastic resistance effect of the strips acting in the direction of the displacement of the collector towards the support perpendicularly to the latter. Such a feature is useful for example when the component or the card to be cooled down is mounted in its housing in the framework by means of a movement perpendicular to the support, so that the collector moves easily in the mounting direction of the component or the card.

According to an advantageous feature, the resilient heat-conducting means comprise at least one metal material.

According to an advantageous feature, the resilient heat-conducting means comprise a first and a second different metal material, the first metal material being chosen for its modulus of elasticity and the second metal material being chosen for its conductivity.

This feature makes it possible to separate the functions of resilient return motion and of conductivity which are distributed respectively to specific flexible strips, for example selected as a function of their position on the device according to the invention.

According to an advantageous feature, the plurality of strips includes at least one first strip realised in the first metal material and at least one second strip realised in the second resilient material.

According to an advantageous feature, the first and second plates are realised in metal material, and the flexible strips are linked to the latter by a link of the welding or soldering type, or similar.

Other features will become apparent in reading about the following exemplary embodiments of a device according to the invention, accompanied by the annexed drawings, these examples being given by way of non-restrictive example.

Fig. 1 represents schematically a longitudinal sectional view of a first embodiment of a device permitting heat transfer from a component or an electronic card to a framework in which it is intended to be mounted.

Figs. 2 and 3 represent schematically the device according to the example of Fig. 1 in two different positions, a rest position for Fig. 2 and an operating position for Fig. 3.

Fig. 4 represents schematically a longitudinal sectional view of a second embodiment of the device permitting heat transfer from a component or an electronic card to a framework in which it is intended to be mounted.

Fig. 5 represents schematically a longitudinal sectional view of a third embodiment of a device permitting heat transfer from a component or an electronic card to a framework in which it is intended to be mounted.

Fig. 6 represents schematically the device according to the example of Fig. 1 in cross-section, mounted in a specific environment.

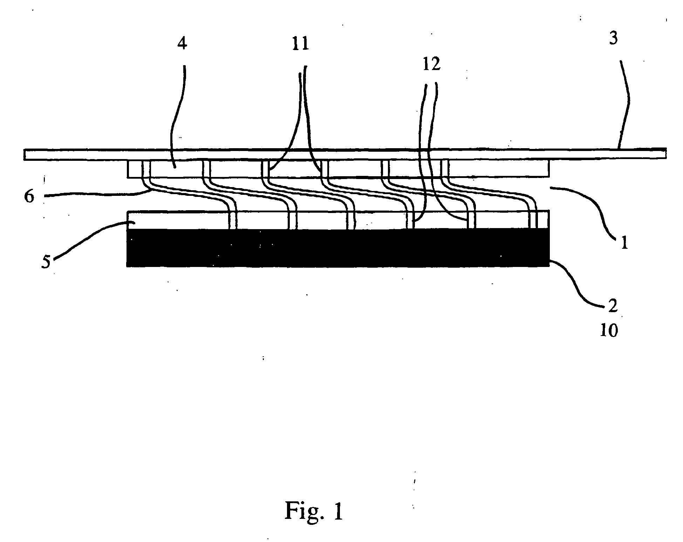

The device 1, represented on Fig. 1, permits a thermal link between a component 10 or an electronic card 2 on the one hand and a framework 3 on the other hand, essentially with a view to transferring heat from the component 10 or the electronic card 2 to the framework 3 in which this card is mounted, and the device comprises:
- a heat-conducting support 4, connected to the framework by a first heat-conducting link,
- a heat-conducting collector 5, connected to the electronic card, by a second heat-conducting link,
- resilient heat-conducting means 6, connecting the heat-conducting support 4 and collector 5 by a resilient heat-conducting link.

The heat-conducting support and collector advantageously take the form of a first 4 and a second 5 rigid heat-conducting plate, respectively, the first heat-conducting link being in this example a rigid link, and the second heat-conducting link being a link by contact. Thus the plate-collector 5 has a planar surface intended to be in contact with the planar surface of the component 10 or the electronic card 2 to be cooled down. On Fig. 1, the electronic card has been schematically represented by a black rectangle, encompassing a number of types of application, as explained below:
- a plurality of electronic components welded onto a card has to be cooled with the device 1 according to the invention; then the black part 2, 10 represented on Fig. 1 comprises:
   * a heat mat, flexible or rigid, placed according to any known means in contact with the plate-collector 5 and hugging the surface of the electronic components to be cooled,
   * the electronic component or components to be cooled and their support card,
- one or more specific components of an electronic card have to be cooled with the device 1 according to the invention; then the black part 2, 10 represented on Fig. 1 represents symbolically the electronic component or components 10 to be cooled, the latter having a planar surface placed in contact with the plate-collector 5, possibly via a heat-conducting contact lubricant according to any known means, if need be, so as to augment the exchange surface limited by the surface roughness of the surfaces in contact.

The first rigid link connecting the support 4 to the framework 3 is realised in any known manner, preferably so as to be detachable, for example by screwing means or similar (not represented).

The second heat-conducting link connecting the heat-conducting collector 5 to the electronic card 2 is advantageously a link by contact but may, in an alternative or additional manner, be realised by a rigid link, detachable, for example by screwing (not represented.

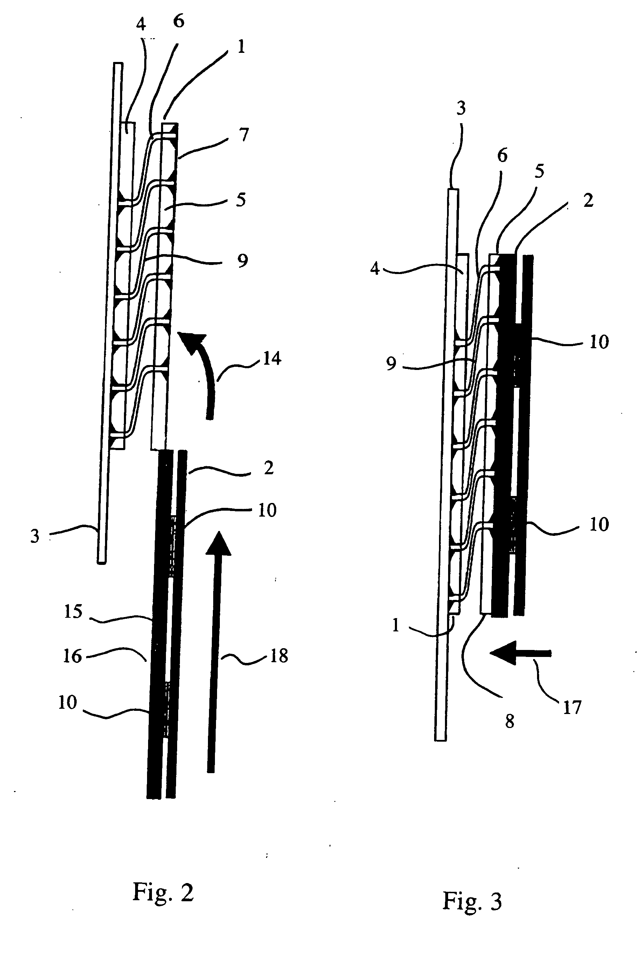

The resilient heat-conducting means 6 advantageously connect the plate-support 4 and the plate-collector 5 in such a way that the latter may assume at least two positions, a first position 7, termed rest position, in which the resilient heat-conducting means 6 are relaxed, and a second position 8, termed operating position, in which the resilient heat-conducting means are compressed. No specific position has been represented on Fig. 1, these being the subject matter of Figs. 2 and 3. The resilient heat-conducting means 6 are preferably arranged in such a way as to permit a resilient displacement in translation of the plate-collector 5 in relation to the plate-support 4, the latter and the plate-collector 5 being parallel or substantially parallel in the operating position. This is due to the fact that electronic cards in an enclosure are generally placed so as to be, once mounted, parallel to certain walls of the framework and perpendicular to others. Thus in order to keep the contact between the plate-collector 5 and the component or components to be cooled, or with the electronic card itself, absorbing possible thermal expansions or manufacturing tolerances, the plate-collector 5 and the plate-support 4 will preferably always be parallel or substantially parallel in their displacement relative to one another.

As represented on Fig. 2, an electronic card 2 is for example introduced into its housing in an enclosure (not represented) by sliding, for example parallel to the wall of the framework 3 to which the heat from the card is to be transferred. Thus the resilient heat-conducting means 6 will advantageously be arranged in such a way that a thrust force parallel to the plate-collector 5, as represented by arrow 18 on Fig. 2, and onto said plate-collector, brings about a displacement of the plate-collector 5 towards the plate-support 4, compressing the resilient heat-conducting means 6, as represented by arrow 14 on Fig. 2 and as will be explained further on in greater detail. The plate-collector 5 can advantageously include an engagement bevel (not represented) intended to facilitate the start of the sliding of the component or of the electronic card on same, during which the resilient means 6 are compressed. On Figs. 2 and 3, the components 10 to be cooled are joined by an intermediate plate 15, the external surface 16 of which is intended to come into contact with the plate-collector 5, as represented on Fig. 3. On Fig. 3, arrow 17 shows the direction of the force exerted by the card on the device 1, perpendicular to plates 4 and 5.

The resilient heat-conducting means 6 advantageously include a plurality of flexible strips 9 rigidly fixed to the heat-conducting support 4 and collector 5 respectively. In an advantageous manner, the plate-collector 5 and the plate-support 4 are realised in metal material, and the flexible strips 9, themselves advantageously realised in metal material, are connected to the latter preferably by a link of the welding or soldering type or similar, in order to improve the thermal conductivity. In an advantageous manner, the plurality of flexible strips 9 includes at least one first strip realised in a first metal material and at least one second strip realised in a second resilient material, different from the first, the first metal material being chosen for its modulus of elasticity, and the second metal material being chosen for its conductivity. Thus although the flexible strips 9 preferably all assume a double functionality of heat conduction and spring, certain strips may assume one of these functions in a preferential manner; a copper strip will have for example a good coefficient of thermal conductivity but a low modulus of elasticity whereas a stainless steel strip will conversely have a good modulus of elasticity but a lower coefficient of conductivity than that of copper. According to requirements, a certain number of strips could be realised in copper for example, the remaining strips being realised for example in stainless steel, according to an appropriate topological distribution, determined as a function of the sought results, for example a uniformly distributed elastic resistance of the strips on the plates 4 and 5, or on the contrary a specific distribution of this elastic resistance. In the example represented, the end flexible strips may be realised in stainless steel for their spring quality and the inside strips, disposed between the end strips, could be realised in copper for their heat-conducting quality. The plates 4 and 5 could for example be realised in aluminium. The good thermal conductivity of the flexible strips permits the transfer of heat from the plate-collector 5 to the plate-support 4. The elastic resistance of the strips will be determined depending on requirements, notably as a function of the surroundings, in order to ensure good permanent thermal contact between the plate-collector 5 and the component or the electronic card to be cooled down, in all operating circumstances.

The shape of the flexible strips 9 will be advantageously defined as a function of the way in which the component 10 or the electronic card 2, with which the device is intended to come into heat-conducting contact, is mounted in the framework 3. According to the example represented on Figs. 1 to 3, the flexible strips 9 of the plurality of strips will advantageously each assume a shape such that it makes it possible to give the plate-collector 5 a displacement in a direction perpendicular to the plate-support 4 and towards the latter, and in a combined manner, a displacement in a direction parallel to the plate-support 4. Thus the electronic card 2 to be cooled down, sliding in its housing in the enclosure when it is put in position, should be stopped against the plate-collector 5 at a predetermined position at the start of its sliding, as represented on Fig. 2, and continuing its sliding in its housing under the action of an operator, the card should push the plate-collector simultaneously towards the front in the sliding direction and towards the plate-support 4 in the direction of the compression of the strips 9, so that the passage for sliding and positioning the card along its sliding axis is cleared and at the end of the sliding, as represented on Fig. 3, the plate-collector 5 is compressed and in position on the component or components 10 to be cooled.

To this end, as represented on Figs. 1 to 3, the resilient strips 9 of the plurality of strips each assume substantially an S-shape, a first branch 11 of the S being fixed to the heat-conducting plate-support 4, the second branch 12 of the S being fixed to the heat-conducting plate-collector 5. Each strip 9 is for example in the form of an S-shaped section, the end branches of the S-shaped section being preferably parallel and embedded one in plate 5 and the other in plate 4, as represented for example on Fig. 1. In the example represented, the branches of the ends of the S-shaped section are respectively perpendicular to the plates 4, 5 on which they are fixed. The insertion of the end branches of the S-shaped section into each plate 4, 5 could assume a depth which is equal or substantially equal to the thickness of the plates, as represented on Figs. 1 to 3, and could be accomplished partially over the length of the flexible strips 9, the strips being welded on the side of the plates 4, 5 in contact with the framework 3 on the one hand and the component 10 or electronic card 2 on the other hand, respectively. The length of the S-shaped section for each strip may correspond to a dimension of the plates 4 or 5, and the S-shaped sections are arranged parallel to one another all along the other dimension of the plates. The flexible strips 9 may touch one another or may remain distant from one another, one interest of the system being to permit a circulation of air in the device between plates 4 and 5, in a direction parallel to the S-shaped sections constituting the strips 9. Stopping strips against one another may constitute a stop for the end of the displacement course of the plate-collector 5 towards the plate-support 4. The S-shaped form of the strips makes it possible to guarantee the parallel alignment of plates 4 and 5 by the principle of a deformable parallelogram.

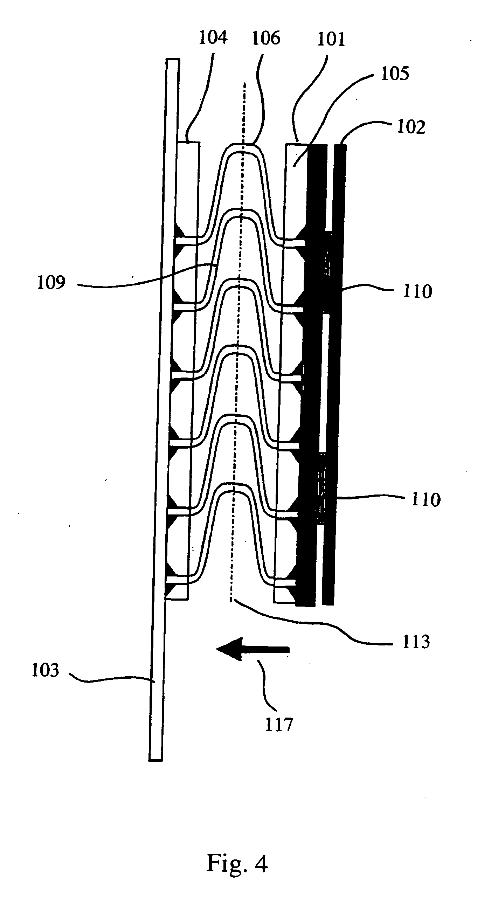

The device 101 according to the second embodiment of a device according to the invention, represented on Fig. 4, comprises elements which are functionally identical to those of the example of Figs. 1 to 3: these functionally identical elements are provided with the same reference number with the addition of the number 100; for these functionally identical elements, reference will be made to the description of the first embodiment according to Figs. 1 to 3.

Device 101 is similar to device 1 and differs from the latter in that the flexible strips 109 of the plurality of strips each assume a symmetrical shape in relation to a plane 113 parallel to the first 104 and second 105 rigid plates. The strips 109 assume for example a U-shape, the ends of the branches of which are made parallel to the base of the U and are embedded respectively in the plate-collector 105 and the plate-support 104, perpendicularly to the latter as represented on Fig. 4, so that the plates 104 and 105 are parallel. Thus the displacement of the plate-collector 104 in relation to the plate-support 104 takes place in a direction perpendicular to plates 104 and 105. Such a device is particularly appropriate when the electronic card 102 bearing the component or components 110 to be cooled is placed in its housing on the framework 103 by a movement perpendicular to the wall of the framework 103 on which the plate-support 104 is fixed, and perpendicular to the plates 104 and 105, a movement in direction 117 on Fig. 4.

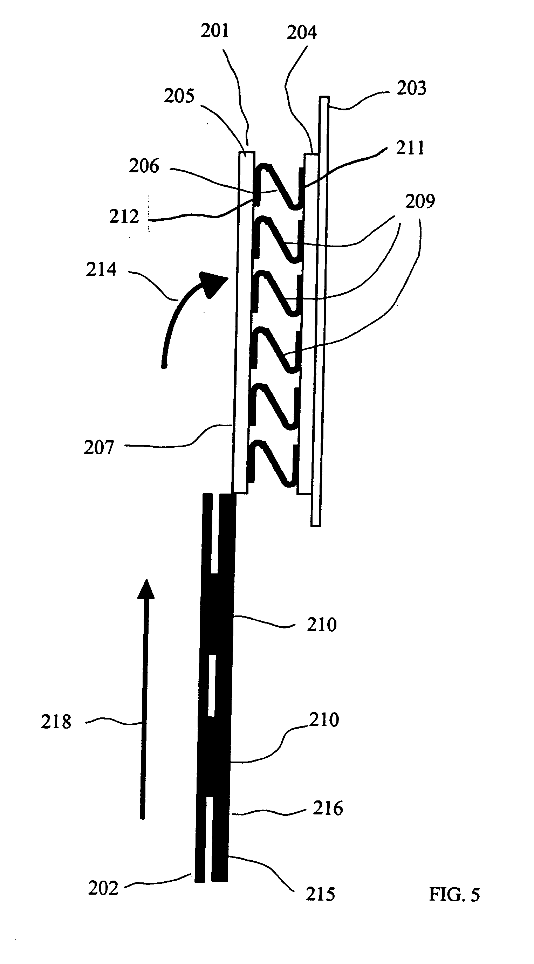

The device 201 according to the third embodiment of a device according to the invention, represented on Fig. 5, comprises elements which are functionally identical to those of the example of Figs. 1 to 3: these functionally identical elements are given the same reference number with the addition of the number 200; for these functionally identical elements, reference will be made to the description of the first embodiment according to Figs. 1 to 3.

Device 201 is similar to device 1 and differs from the latter in that the flexible strips 209 of the plurality of strips each assumes substantially a Z-shape, a first branch 211 of the Z being fixed to the heat-conducting plate-support 204, the second branch 212 of the Z being fixed to the heat-conducting plate-collector 205. Each strip 209 is for example in the form of a Z-shaped section, the end branches of the Z-shaped section being preferably parallel and welded one onto the external surface of plate 205, the other onto the external surface of plate 204, as represented on Fig. 5.

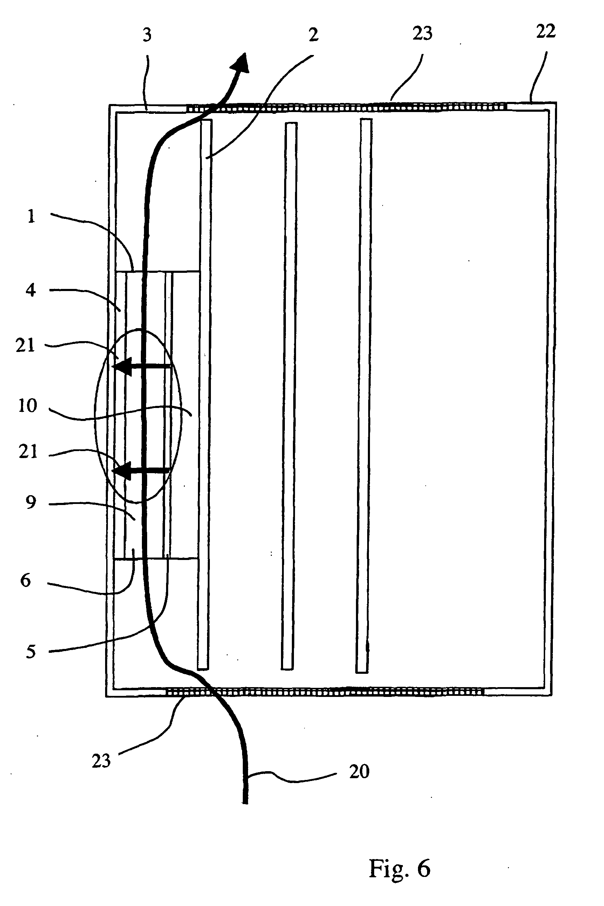

On Fig. 6 is given a schematic example of application of the device 1, in which an airflow 20 is represented, providing cooling by convection of the component 10 or of the card 2, by circulation of the airflow 20 through the enclosure 22 between the flexible strips 9, parallel to plates 4 and 5 and to strips 9, combined with cooling by conduction to the framework in direction 121 perpendicular to plates 4 and 5. For the purpose of evacuating the heat by convection away from the enclosure 22, the airflow 20 crosses the enclosure 22 via openings 23 provided to this end.

The device according to the invention makes it possible to let the electronics cooled by said device function at a temperature greater than that of electronics cooled with conventional heat dissipators such as described in the prior art before this document. By way of example, a conventional operating temperature is of the order of 55°C, whilst the device according to the invention makes it possible to ensure cooling of the electronics at an operating temperature of 71°C. The invention finds application in closed or open enclosures. The device according to the invention finds particularly advantageous application when a saving of weight has to be realised or when the mechanical construction tolerances are wide or when cooling by convection may be combined with cooling by conduction. The device according to the invention does not require any maintenance and is easily mounted due to the automatic return of the plate-collector to the rest position. Particularly appropriate fields of application are aeronautics and defence; the device according to the invention could advantageously be used as a heat dissipator in normal operating conditions in the presence of an airflow; the heat generated by the electronics is then dissipated by convection by the device according to the invention; in the case of loss of cooling conditions, the thermal conduction link offered by the device according to the invention becomes more important than the convection and permits the electronics to function without forced air.

## Claims

1. Device (1, 101, 201) permitting heat transfer, especially from a component (10, 110, 210) or an electronic card (2, 102, 202) to a framework (3, 103, 203) in which it is intended to be mounted, or to a heat dissipator linked to said framework, **wherein** the device comprises:
a heat-conducting support (4, 104, 204), intended to be connected to the framework or heat dissipator by a first heat-conducting link,
- a heat-conducting collector (5, 105, 205), heat-conducting collector (5, 105, 205), intended to be connected to the component or electronic card, by a second heat-conducting link,
- resilient heat-conducting means (6, 106, 206), connecting the heat-conducting support and collector by a resilient heat-conducting link, comprising a plurality of flexible strips (9, 109, 209).

2. Device according to claim 1, **characterised in that** one of said first or second heat-conducting links is a rigid link, the other being a link by contact, the support or collector which ensures said link by contact being rigid.

3. Device according to claim 2, **characterised in that** the first heat-conducting link is a rigid link, the second heat-conducting link being a link by contact.

4. Device according to any one of claims 1 to 3, **characterised in that** the resilient heat-conducting means (6) connect the support (4) and the collector (5) in such a way that the latter may adopt at least two positions, a first position (7), termed rest position, in which the resilient heat-conducting means (6) are relaxed, and a second position (8), termed operating position, in which the resilient heat-conducting means are compressed.

5. Device according to any one of claims 1 to 4, **characterised in that** the resilient heat-conducting means (6, 106, 206) are arranged in such a way as to permit a resilient displacement in translation of the collector (5, 105, 205) in relation to the support (4, 104, 204).

6. Device according to claims 4 and 5, **characterised in that** the support (4, 104, 204) and the collector (5, 105, 205) are parallel or substantially parallel in the operating position.

7. Device according to any one of claims 1 to 6, **characterised in that** the heat-conducting support and collector respectively take the form of a first (4, 104, 204) and a second (5, 105, 205) rigid heat-conducting plate.

8. Device according to claim 7, **characterised in that** the resilient heat-conducting means (6, 206) are arranged in such a way that a thrust force parallel to the second (5, 205) plate and on same brings about a displacement of the second plate towards the first (4, 204) plate, compressing the resilient heat-conducting means.

9. Device according to claims 7 and 8, **characterised in that** the second plate includes an engagement bevel intended to facilitate the sliding of the component or of the electronic card on the second plate.

10. Device according to any one of claims 1 to 9, **characterised in that** the resilient heat-conducting means (6, 106, 206) comprise a plurality of flexible strips (9, 109, 209) rigidly fixed to the heat-conducting support (4, 104, 204) and to the heat-conducting collector (5, 105, 205) respectively.

11. Device according to claim 10, **characterised in that** the flexible strips (9, 209) of the plurality of strips each assume substantially an S- or Z-shape such that it enables the collector (5, 205) to be given a displacement in a direction perpendicular to the support (4, 204) and towards the latter, and in a combined manner, a displacement in a direction parallel to the support, a first branch (11, 211) of the S or of the Z being fixed to the heat-conducting support (4, 204), the second branch (12, 212) of the S or of the Z being fixed to the heat-conducting collector (5, 205).

12. Device according to claims 7 and 10, **characterised in that** the flexible strips (109) of said plurality of strips each assume a symmetrical shape in relation to a plane (113) parallel to the first (104) and second (105) rigid plates.

13. Device according to any one of claims 1 to 12, **characterised in that** the resilient heat-conducting means (6, 106, 206) comprise at least one metal material.

14. Device according to claim 13, **characterised in that** the resilient heat-conducting means (6, 106, 206) comprise a first and a second different metal material, the first metal material being chosen for its modulus of elasticity and the second metal material being chosen for its conductivity.

15. Device according to claims 10 and 14, **characterised in that** the plurality of strips includes at least one first strip realised in the first metal material and at least one second strip realised in the second resilient material.

16. Device according to claims 7, 10 and 13, **characterised in that** the first and second plates are realised in metal material and **in that** the flexible strips are connected to the latter by a link of the welding or soldering type, or similar.

## Patentansprüche

1. Vorrichtung (1, 101, 201), welche Wärmeübertragung insbesondere von einem Bauelement (10, 110, 210) oder einer elektronischen Karte (2, 102, 202) zu einem Rahmen (3, 103, 203) erlaubt, in welchem sie bestimmt ist, befestigt zu sein, oder an einen Wärmeableiter, welcher mit dem Rahmen in Verbindung ist, wobei die Vorrichtung umfasst:
- einen wärmeleitenden Halter (4, 104, 204), welcher dafür bestimmt ist, mit dem Rahmen oder dem Wärmeableiter durch eine erste wärmeleitende Verbindung verbunden zu sein,
- einen wärmeleitenden Kollektor (5, 105, 205), welcher dafür bestimmt ist, mit dem Bauteil oder der elektronischen Karte durch eine zweite wärmeleitende Verbindung verbunden zu sein,
- federnde wärmeleitende Mittel (6, 106, 206), welche den wärmeleitenden Halter und den Kollektor durch eine federnde wärmeleitende Verbindung verbinden, welche mehrere flexible Streifen (9, 109, 209) umfasst.

2. Vorrichtung nach Anspruch 1, **dadurch gekennzeichnet, dass** eine, die erste oder die zweite, wärmeleitende Verbindung eine feste Verbindung ist, wobei die andere eine Kontaktverbindung ist, wobei der Halter oder der Kollektor, welcher die Kontaktverbindung sichert, fest ist.

3. Vorrichtung nach Anspruch 2, **dadurch gekennzeichnet, dass** die erste wärmeleitende Verbindung eine feste Verbindung ist, wobei die zweite wärmeleitende Verbindung eine Kontaktverbindung ist.

4. Vorrichtung nach einem der Ansprüche 1 bis 3, **dadurch gekennzeichnet, dass** die federnden wärmeleitenden Mittel (6) den Halter (4) und den Kollektor (5) auf solche Weise verbinden, dass der Letztere wenigstens zwei Positionen einnehmen kann, eine erste Position (7), bezeichnet als Ruheposition, in welcher die federnden wärmeleitenden Mittel (6) entspannt sind, und eine zweite Position (8), bezeichnet als Betriebsposition, in welcher die federnden wärmeleitenden Mittel gedrückt sind.

5. Vorrichtung nach einem der Ansprüche 1 bis 4, **dadurch gekennzeichnet, dass** die federnden wärmeleitenden Mittel (6, 106, 206) auf solche Weise angeordnet sind, dass sie ein federndes translatorisches Verschieben des Kollektors (5, 105, 205) bezogen auf den Halter (4, 104, 204) erlauben.

6. Vorrichtung nach Anspruch 4 und 5, **dadurch gekennzeichnet, dass** der Halter (4, 104, 204) und der Kollektor (5, 105, 205) in der Betriebsposition parallel oder im Wesentlichen parallel sind.

7. Vorrichtung nach einem der Ansprüche 1 bis 6, **dadurch gekennzeichnet, dass** der wärmeleitende Halter und der Kollektor jeweils die Form einer ersten (4, 104, 204) und einer zweiten (5, 105, 205) festen wärmeleitenden Platte annehmen.

8. Vorrichtung nach Anspruch 7, **dadurch gekennzeichnet, dass** die federnden wärmeleitenden Mittel (6, 206) auf solche Weise angeordnet sind, dass eine Druckkraft, parallel zu der zweiten Platte (5, 205) und auf dieselbe, ein Verschieben der zweiten Platte hin zu der ersten Platte (4, 204) herbeiführt, wobei die federnden wärmeleitenden Mittel gedrückt werden.

9. Vorrichtung nach Anspruch 7 und 8, **dadurch gekennzeichnet, dass** die zweite Platte eine Einsteckfase enthält, welche dafür bestimmt ist, das Gleiten des Bauelements oder der elektronischen Karte an der zweiten Platte zu erleichtern.

10. Vorrichtung nach einem der Ansprüche 1 bis 9, **dadurch gekennzeichnet, dass** die federnden wärmeleitenden Mittel (6, 106, 206) mehrere flexible Streifen (9, 109, 209) umfassen, welche jeweils an dem wärmeleitenden Halter (4, 104, 204) und an dem wärmeleitenden Kollektor (5, 105, 205) fix befestigt sind.

11. Vorrichtung nach Anspruch 10, **dadurch gekennzeichnet, dass** die flexiblen Streifen (9, 209) der mehreren Streifen je im Wesentlichen eine S- oder Z-Form annehmen, derart, dass das dem Kollektor (5, 205) ermöglicht, eine Verschiebung in eine Richtung rechtwinkelig zu dem Halter (4, 204) und zu dem Letzteren hin zu erfahren, und, auf eine kombinierte Art, eine Verschiebung in eine Richtung parallel zu dem Halter, wobei ein erster Arm (11, 211) des S oder des Z an dem wärmeleitenden Halter (4, 204) fixiert ist, wobei der zweite Arm (12, 212) des S oder des Z an dem wärmeleitenden Kollektor (5, 205) fixiert ist.

12. Vorrichtung nach Anspruch 7 und 10, **dadurch gekennzeichnet, dass** die flexiblen Streifen (109) der mehreren Streifen je eine symmetrische Form bezogen auf eine Ebene (113) annehmen, welche parallel ist zu der ersten (104) und der zweiten (105) festen Platte.

13. Vorrichtung nach einem der Ansprüche 1 bis 12, **dadurch gekennzeichnet, dass** die federnden wärmeleitenden Mittel (6, 106, 206) wenigstens ein Metallmaterial umfassen.

14. Vorrichtung nach Anspruch 13, **dadurch gekennzeichnet, dass** die federnden wärmeleitenden Mittel (6, 106, 206) ein erstes und ein zweites unterschiedliches Metallmaterial umfassen, wobei das erste Metallmaterial auf Grund seines Elastizitätsmoduls ausgewählt ist, und wobei das zweite Metallmaterial auf Grund seiner Wärmeleitfähigkeit ausgewählt ist.

15. Vorrichtung nach Anspruch 10 und 14, **dadurch gekennzeichnet, dass** die mehreren Streifen wenigstens einen ersten Streifen umfassen, welcher in dem ersten Metallmaterial ausgeführt ist, und wenigstens einen zweiten Streifen, welcher in dem zweiten federnden Material ausgeführt ist.

16. Vorrichtung nach Anspruch 7, 10 und 13, **dadurch gekennzeichnet, dass** die erste und die zweite Platte in Metallmaterial ausgeführt sind, und **dadurch**, dass die flexiblen Streifen mit der Letzteren durch eine Verbindung von der Art einer Schweiß- oder Lötverbindung, oder ähnlicher Art, verbunden sind.

## Revendications

1. Dispositif (1, 101, 201) permettant un transfert thermique, notamment d'un composant (10, 110, 210) ou d'une carte électronique (2, 102, 202) vers un châssis (3, 103, 203) dans lequel il ou elle est destiné à être monté, ou vers un dissipateur de chaleur lié au dit châssis, dans lequel le dispositif comprend :
- un support (4, 104, 204) thermoconducteur, destiné à être connecté au châssis ou dissipateur de chaleur par une première liaison thermoconductrice,
- un collecteur (5, 105, 205) thermoconducteur, destiné à être connecté au composant ou carte électronique, par une deuxième liaison thermoconductrice,
- des moyens élastiques (6, 106, 206) thermoconducteurs, reliant le support et le collecteur thermoconducteurs par une liaison élastique thermoconductrice, comprenant une pluralité de lames flexibles (9, 109, 209)..

2. Dispositif selon la revendication 1, ***caractérisé en ce que*** l'une desdites première ou deuxième liaison thermoconductrice est une liaison rigide, l'autre étant une liaison par contact, celui desdits support ou collecteur assurant la ladite liaison par contact étant rigide.

3. Dispositif selon la revendication 2, ***caractérisé en ce que*** la première liaison thermoconductrice est une liaison rigide, la deuxième liaison thermoconductrice étant une liaison par contact.

4. Dispositif selon l'une quelconque des revendications 1 à 3, ***caractérisé en ce que*** les moyens élastiques thermoconducteurs (6) relient le support (4) et le collecteur (5) de sorte que ces derniers puissent adopter au moins deux positions, une première position (7), dite position de repos, dans laquelle les moyens élastiques thermoconducteurs (6) sont détendus, et une deuxième position (8), dite position de travail, dans laquelle les moyens élastiques thermoconducteurs sont comprimés.

5. Dispositif selon la revendication l'une quelconque des revendications 1 à 4, ***caractérisé en ce que*** les moyens élastiques thermoconducteurs (6, 106, 206) sont agencés de manière à permettre un déplacement élastique en translation du collecteur (5, 105, 205) par rapport au support (4, 104, 204).

6. Dispositif selon les revendications 4 et 5, ***caractérisé en ce que*** le support (4, 104, 204) et le collecteur (5, 105, 205) sont parallèles ou sensiblement parallèles en position de travail

7. Dispositif selon l'une quelconque des revendications 1 à 6, ***caractérisé en ce que*** le support et le collecteur thermoconducteurs adoptent la forme d'une première (4, 104, 204) et d'une deuxième (5, 105, 205) plaques rigides thermoconductrices, respectivement.

8. Dispositif selon la revendication 7, ***caractérisé en ce que*** les moyens élastiques thermoconducteurs (6, 206) sont agencés de telle sorte qu'un effort de poussée parallèle à la deuxième (5, 205) plaque et sur celle-ci entraîne un déplacement de la deuxième plaque vers la première (4, 204) plaque en comprimant les moyens élastiques thermoconducteurs.

9. Dispositif selon les revendications 7 et 8, ***caractérisé en ce que*** la deuxième plaque comprend un chanfrein d'attaque destiné à faciliter un glissement du composant ou de la carte électronique sur la deuxième plaque.

10. Dispositif selon l'une quelconque des revendications 1 à 9, ***caractérisé en ce que*** les moyens élastiques thermoconducteurs (6, 106, 206) comprennent une pluralité de lames flexibles (9, 109, 209) fixées rigidement au support (4, 104, 204) et au collecteur (5, 105, 205) thermoconducteurs, respectivement.

11. Dispositif selon la revendication 10, ***caractérisé en ce que*** les lames élastiques (9, 209) de la pluralité de lames adoptent chacune sensiblement une forme de S ou de Z, telle qu'elle permet de conférer au collecteur (5, 205) un déplacement selon une direction perpendiculaire au support (4, 204) et vers celui-ci, et de manière combinée, un déplacement dans une direction parallèle au support, une première branche (11,211) du S ou du Z étant fixée au support (4, 204) thermoconducteur, la deuxième branche (12, 212) du S ou du Z étant fixée au collecteur (5, 205) thermoconducteur.

12. Dispositif selon les revendications 7 et 10, ***caractérisé en ce que*** les lames flexibles (109) de ladite pluralité de lames adoptent chacune une forme symétrique par rapport à un plan (113) parallèle aux première (104) et deuxième (105) plaques rigides.

13. Dispositif selon l'une quelconque des revendications 1 à 12, ***caractérisé en ce que*** les moyens élastiques (6, 106, 206) thermoconducteurs comprennent au moins un matériau métallique.

14. Dispositif selon la revendication 13, ***caractérisé en ce que*** les moyens élastiques (6, 106, 206) thermoconducteurs comprennent un premier et un deuxième matériaux métalliques différents, le premier matériau métallique étant choisi pour son module d'élasticité, et le deuxième matériau métallique étant choisi pour sa conductibilité.

15. Dispositif selon les revendications 10 et 14, ***caractérisé en ce que*** la pluralité de lames comprend au moins une première lame réalisée dans le premier matériau métallique et au moins une deuxième lame réalisée dans le deuxième matériau élastique.

16. Dispositif selon les revendications 7, 10 et 13, ***caractérisé en ce que*** les première et deuxième plaques sont réalisées en matériau métallique, et **en ce que** les lames flexibles sont liées à ces dernières par une liaison de type soudage, brasage, ou analogue.
